# EUROPEAN PATENT APPLICATION

(11) **EP 2 408 037 A1**
(43) Date of publication of application: **18.01.2012**
(21) Application number: 10750705.5
(22) Date of filing: 01.03.2010
(51) Int. Cl.: H01L 51/50, C08F 212/02, C08F 224/00, C09K 11/06, H05B 33/02, H05B 33/22

(54) **ORGANIC LIGHT-EMITTING ELEMENT MATERIAL, ORGANIC LIGHT-EMITTING ELEMENT, AND PROCESS FOR PRODUCING SAME**

(30) Priority: 09.03.2009 JP 2009055466
(71) Applicant: Showa Denko K.K., Tokyo 105-8518 (JP)
(72) Inventor: KATOH, Tsuyoshi, Chiba-shi Chiba 267-0056 (JP)
(74) Representative: Strehl Schübel-Hopf & Partner
(86) International application number: PCT/JP2010/053262
(87) International publication number: WO 2010/103951

(57) **Abstract**

[Problem] To provide an organic light-emitting element material which can be favorably used for obtaining an organic light-emitting element that emits light with high luminance, exhibits high external quantum efficiency and has excellent durability.

[Solution to Problem] An organic light-emitting element material which is a high-molecular compound including k% by mol (0<k≤100) of a constitutional unit represented by the following formula (1a) and n% by mol (0≤n<100 and k+n=100) of a constitutional unit represented by the following formula (1b). 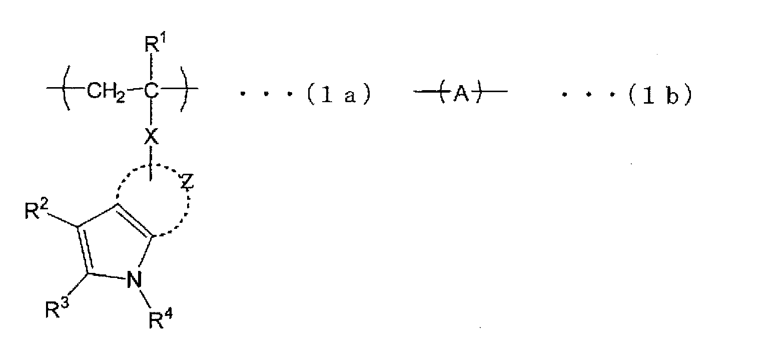 In the formula (1a), R¹ is a hydrogen atom or a methyl group, R² and R³ are each independently a hydrogen atom or a substituent group and may be bonded to each other to form a ring, R⁴ is a hydrogen atom, or a substituted or unsubstituted alkyl group, alkenyl group, alkynyl group, aryl group, heterocyclic group, alkylcarbonyl group, arylcarbonyl group, alkylsulfonyl group, arylsulfonyl group, alkoxycarbonyl group, aryloxycarbonyl group, carbamoyl group or sulfamoyl group, Z is an atomic group that forms an aromatic ring, and X is a divalent linkage group. In the formula (1b), A is a copolymerized monomer unit derived from a vinyl monomer.

## Description

### Technical Field

The present invention relates to an organic light-emitting element material, an organic light-emitting element using the material and a process for producing the organic light-emitting element.

### Background Art

Studies and developments of various display elements have been actively carried out in these days. Of these, organic light-emitting elements (also referred to as "organic EL elements" hereinafter) are capable of light emission with high luminance at a low voltage, so that they have been paid attention, and for example, an organic light-emitting element having an organic thin film formed by deposition of an organic compound is known (Applied PhysicsLetters, 51, 913 (1987)). Thisorganiclight-emittingelement has a structure in which an electron transporting material and a hole transporting material are laminated upon each other, and its light emission properties have been greatly enhanced as compared with those of conventional single-layer type elements. As the hole transporting material, TPD (N,N'-di-m-tolyl-N,N'-diphenylbenzidine) is used. A triarylamine derivative such as TPD is one of most effective hole transporting materials. However, the triarylamine derivative has high crystallinity, and an organic light-emitting element using the triarylamine derivative has a problem in storability. From the viewpoints of simplification of production process, improvement of processability, increase of area of element, etc., it is desirable to produce an organic light-emitting element by a coating method, but the triarylamine derivative is unsuitable for the coating method because it has low solubility in organic solvents.

As the hole transporting material substituted for the triarylamine derivative, a nitrogen-containing heterocyclic compound such as a carbazole derivative has been studied. For example, in the 6th seminar preliminary report at Molecular Electronics and Bioelectronics Division of the Japan Society of Applied Physics (1997), many examples of studies on the technique to use a low-molecular carbozole derivative or a poly-N-vinylcarbazole derivative as the hole transporting material are described. In the organic light-emitting element using such a hole transporting material, however, there are problems that the driving voltage is high and the luminous efficiency is bad.

In JP-A-2002-105445 (patent literature 1), a high-molecular compound in which a specific pyrrole derivative such as a carbazole derivative is directly bonded to the main chain is described as an organic light-emitting element material, but an organic light-emitting element using this material is insufficient in durability and luminance.

### Citation List

### Patent Literature

Patent literature 1: JP-A-2002-105445

### Summary of Invention

### Technical Problem

It is an object of the present invention to provide an organic light-emitting element material which can be favorably used for obtaining an organic light-emitting element that emits light with high luminance, exhibits high external quantum efficiency and has excellent durability, an organic light-emitting element using the material and a process for producing the element.

### Solution to Problem

As a result of earnest studies in view of the above object, the present inventor has found that an organic light-emitting element containing, in its organic layer, a high-molecular compound in which a specific pyrrole derivative is bonded to the main chain through a linkage group emits light with high luminance, exhibits high external quantum efficiency and has excellent durability, and he has accomplished the present invention.

The present invention relates to, for example, the following [1] to [12].

### [1]

An organic light-emitting element material which is a high-molecular compound comprising k% by mol (0<k≤100) of a constitutional unit represented by the following formula (1a) and n% by mol (0≤n<100 and k+n=100) of a constitutional unit represented by the following formula (1b)

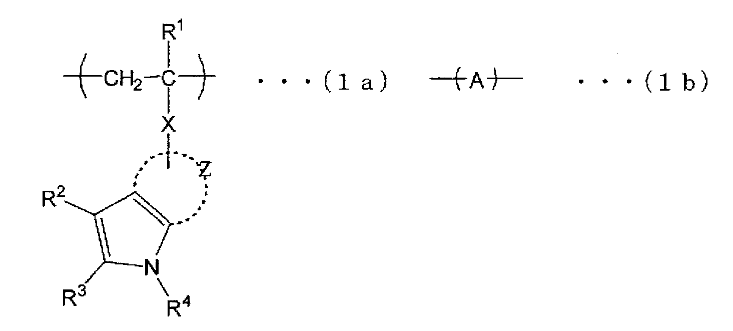

In the formula (1a), R¹ is a hydrogen atom or a methyl group,
R² and R³ are each independently a hydrogen atom or a substituent group and may be bonded to each other to form a ring,
R⁴ is a hydrogen atom, or a substituted or unsubstituted alkyl group, alkenyl group, alkynyl group, aryl group, heterocyclic group, alkylcarbonyl group, arylcarbonyl group, alkylsulfonyl group, arylsulfonyl group, alkoxycarbonyl group, aryloxycarbonyl group, carbamoyl group or sulfamoyl group,
Z is an atomic group that forms an aromatic ring, and
X is a divalent linkage group.

In the formula (1b), A is a copolymerized monomer unit derived from a vinyl monomer.
In the present specification, this high-molecular compound is sometimes represented by the following formula (1).

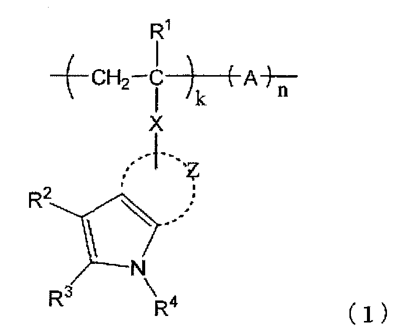

wherein R¹, R², R³, R⁴, Z, X, A, k and n are as previously described.
However, the representation by this formula (1) is used for convenience, and the high-molecular compound represented by this formula (1) is not limited to a block copolymer comprising a block consisting of k% by mol of constitutional units represented by the formula (1a) and a block consisting of n% by mol of constitutional units represented by the formula (1b)

### [2]

The organic light-emitting element material as stated in [1], wherein X in the formula (1a) is selected from an alkylene group, an arylene group and a divalent aromatic heterocyclic group.

### [3]

The organic light-emitting element material as stated in [1] or [2], wherein the aromatic ring formed from Z in the formula (1a) is a benzene ring.

### [4]

The organic light-emitting element material as stated in [3], which is a high-molecular compound comprising k% by mol (0<k≤100) of a constitutional unit represented by the following formula (2a) and n% by mol (0≤n<100 and k+n=100) of a constitutional unit represented by the following formula (2b).

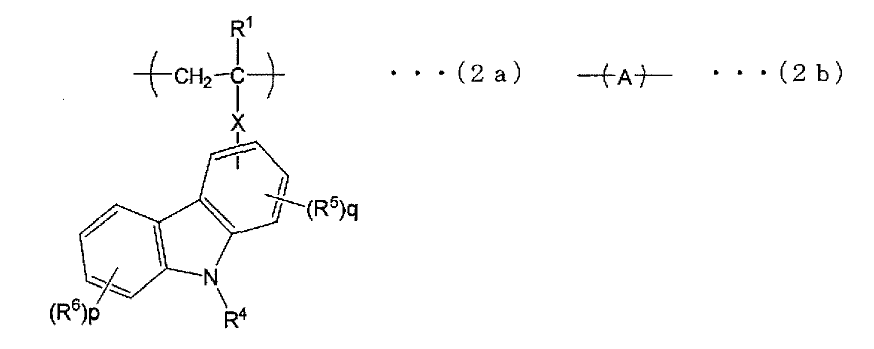

In the formula (2a), R¹ is a hydrogen atom or a methyl group,
R⁴ is a hydrogen atom, or a substituted or unsubstituted alkyl group, alkenyl group, alkynyl group, aryl group, heterocyclic group, alkylcarbonyl group, arylcarbonyl group, alkylsulfonyl group, arylsulfonyl group, alkoxycarbonyl group, aryloxycarbonyl group, carbamoyl group or sulfamoyl group,
R⁵ and R⁶ are each independently a substituent group,
p is an integer of 0 to 4,
q is an integer of 0 to 3, and
X is a divalent linkage group.

In the formula (2b), A is a copolymerized monomer unit derived from a vinyl monomer.
In the present specification, this high-molecular compound is sometimes represented by the following formula (2).

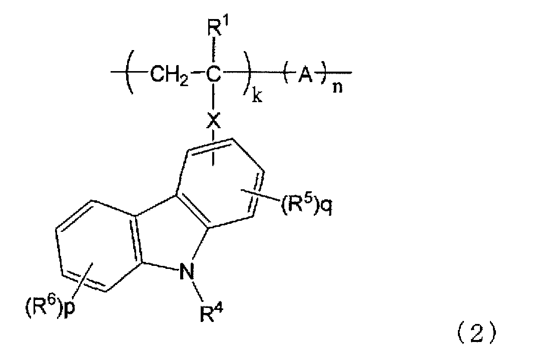

wherein R¹, R⁴, R⁵ R⁶, p, q, X, A, k and n are as previously described.
However, the representation by this formula (2) is used for convenience, and the high-molecular compound represented by this formula (2) is not limited to a block copolymer comprising a block consisting of k% by mol of constitutional units represented by the formula (2a) and a block consisting of n% by mol of constitutional units represented by the formula (2b).

### [5]

An organic light-emitting element which is an organic light-emitting element having an organic layer (s) between a pair of electrodes, wherein at least one of the organic layer(s) contains the organic light-emitting element material as stated in any one of [1] to [4].

### [6]

The organic light-emitting element as stated in [5], wherein at least one of the organic layer (s) comprises a luminescent material capable of light emission from a triplet exciton.

### [7]

An organic light-emitting element having a hole injection electrode layer, an electron injection electrode layer and a dielectric layer interposed between the hole injection electrode layer and the electron injection electrode layer,
having a cavity which extends through the dielectric layer and at least one of these electrode layers and has an internal cavity surface provided with a hole injection electrode region, an electron injection electrode region and a dielectric region, and
having an organic layer which comprises the organic light-emitting element material as stated in any one of [1] to [4] and is in electrical contact with the hole injection electrode region and the electron injection electrode region on the internal cavity surface.

### [8]

The organic light-emitting element as stated in [7], wherein the organic layer contains a luminescent material capable of light emission from a triplet exciton.

### [9]

Aprocess for producing an organic light-emitting element, which is a process for producing an organic light-emitting element having an organic layer between a pair of electrodes, the said process comprising a step of forming the organic layer comprising the organic light-emitting element material as stated in any one of [1] to [4] on one of the electrodes and a step of forming the other of the electrodes on the organic layer.

### [10]

The process for producing an organic light-emitting element as stated in [9], wherein the step of forming the organic layer comprises applying a liquid comprising at least the organic light-emitting element material as stated in any one of [1] to [4] onto one of the electrodes to form the organic layer.

### [11]

A process for producing an organic light-emitting element, comprising:
a step of forming a laminated structure having a hole injection electrode layer, an electron injection electrode layer and a dielectric layer interposed between the hole injection electrode layer and the electron injection electrode layer and having a cavity which extends through the dielectric layer and at least one of these electrode layers and has an internal cavity surface provided with a hole injection electrode region, an electron injection electrode region and a dielectric region, and
a step of forming an organic layer comprising the organic light-emitting element material as stated in any one of [1] to [4] on the internal cavity surface in such a manner that the organic layer comes into electrical contact with the hole injection electrode region and the electron injection electrode region on the internal cavity surface.

### [12]

The process for producing an organic light-emitting element as stated in [11], wherein the organic layer further contains a luminescent material capable of light emission from a triplet exciton.

### Advantageous Effects of Invention

The organic light-emitting element containing the organic light-emitting element material of the present invention emits light with high luminance, exhibits high external quantum efficiency and has excellent durability.

### Brief Description of Drawings

Fig. 1 is a schematic sectional view of one embodiment of the organic light-emitting element of the present invention.
Fig. 2 is a schematic sectional view of one embodiment of the organic light-emitting element (organic light-emitting element with cavity) of the present invention.

### Description of Embodiments

### [1] Organic light-emitting element material

The organic light-emitting element material of the present invention is a high-molecular compound represented by the following formula (1).

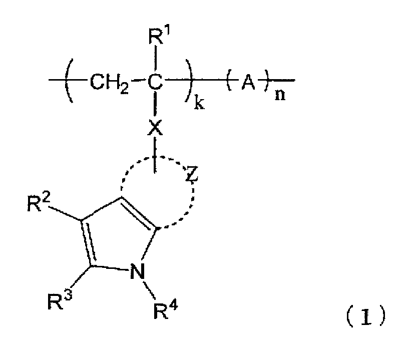

In the formula (1), R¹ is a hydrogen atom or a methyl group. R² and R³ are each independently a hydrogen atom or a substituent group, and may be bonded to each other to form a ring

When R² and R³ are substituent groups, examples thereof include:
halogen atom (e.g., fluorine atom, chlorine atom, bromine atom or iodine atom),
cyano group,
sulfo group (-SO₃H),
formyl group,
carboxyl group,
alkyl group (preferably having 1 to 30 carbon atoms, more preferably having 1 to 15 carbon atoms, e.g., methyl group, t-butyl group or cyclohexyl group),
alkenyl group (preferably having 2 to 30 carbon atom, more preferably having 2 to 15 carbon atoms, e.g., vinyl group, 1-propenyl group, 1-buten-2-yl group or cyclohexen-1-yl group),
alkynyl group (preferably having 2 to 30 carbon atom, more preferably having 2 to 15 carbon atoms, e.g., ethynyl group or 1-propynyl group),
aryl group (preferably having 6 to 30 carbon atom, more preferably having 6 to 15 carbon atoms, e.g., phenyl group, tolyl group, xylyl group, naphthyl group, biphenylyl group or pyrenyl group),
heterocyclic group (preferably having 2 to 30 carbon atom, more preferably having 2 to 15 carbon atoms; it preferably has a five-or six-membered ring structure and may be condensed with another ring, and the hetero atom may be nitrogen atom, oxygen atom, sulfur atom or the like; e.g., pyridyl group, piperidyl group, oxazolyl group, oxadiazolyl group, tetrahydrofuryl group or thienyl group),
primary to tertiary amino group (preferably having 1 to 30 carbon atom, more preferably having 1 to 16 carbon atoms; it may be amino group, monoalkylamino group, monoarylamino group, dialkylamino group, diarylamino group, alkylarylamino group, monoheterocyclic amino group, bisheterocyclic amino group or the like, and is preferably tertiary amino group; e.g., dimethylamino group, diphenylamino group or phenylnaphthylamino group),
imino group (preferably having 1 to 30 carbon atoms, more preferably having 1 to 15 carbon atoms; it may be a group represented by -CR¹¹=NR¹² or -N=CR¹³R¹⁴ (R¹¹ to R¹⁴ are each independently hydrogen atom, alkyl group, aryl group, heterocyclic group, alkoxy group, aryloxy group or primary to tertiary amino group)),
alkoxy group (preferably having 1 to 30 carbon atoms, more preferably having 1 to 15 carbon atoms, e. g. , methoxy group, ethoxy group or cyclohexyloxy group),
aryloxy group (preferably having 6 to 30 carbon atoms, more preferably having 6 to 15 carbon atoms, e.g., phenoxy group, 1-naphthoxy group or 4-phenylphenoxy group),
alkylthio group (preferably having 1 to 30 carbon atoms, more preferably having 1 to 15 carbon atoms, e.g., methylthio group, ethylthio group or cyclohexylthio group),
arylthio group (preferably having 6 to 30 carbon atoms, more preferably having 6 to 15 carbon atoms, e.g., phenylthio group or tolylthio group),
carbonamide group (preferably having 1 to 30 carbon atoms, more preferably having 1 to 15 carbon atoms, e.g., acetamide group, benzoylamide group or N-methylbenzoylamide group),
sulfonamide group (preferably having 1 to 30 carbon atoms, more preferably having 1 to 15 carbon atoms, e.g., methanesulfonamide group, benzenesulfonamide group or p-toluenesulfonamide group),
carbamoyl group (preferably having 1 to 30 carbon atoms, more preferably having 1 to 15 carbon atoms, e.g., unsubstituted carbamoyl group, methylcarbamoyl group, dimethylcarbamoyl group, phenylcarbamoyl group, diphenylcarbamoyl group or dioctylcarbamoyl group),
sulfamoyl group (preferably having 1 to 30 carbon atoms, more preferably having 1 to 15 carbon atoms, e.g., unsubstituted sulfamoyl group, methylsulfamoyl group, dimethylsulfamoyl group, phenylsulfamoyl group, diphenylsulfamoyl group or dioctylsulfamoyl group),
alkylcarbonyl group (preferably having 2 to 30 carbon atoms, more preferably having 2 to 15 carbon atoms, e.g., acetyl group, propionyl group, butyroyl group or lauroyl group),
arylcarbonyl group (preferably having 6 to 30 carbon atoms, more preferably having 6 to 15 carbon atoms, e.g., benzoyl group or naphthoyl group),
alkylsulfonyl group (preferably having 1 to 30 carbon atoms, more preferably having 1 to 15 carbon atoms, e.g., methanesulfonyl group or ethanesulfonyl group),
arylsulfonyl group (preferably having 6 to 30 carbon atoms, more preferably having 6 to 15 carbon atoms, e.g., benzenesulfonyl group, p-toluenesulfonyl group or 1-naphthalenesulfonyl group),
alkoxycarbonyl group (preferably having 2 to 30 carbon atom, more preferably having 2 to 15 carbon atoms, e.g., methoxycarbonyl group, ethoxycarbonyl group or butoxycarbonyl group),
aryloxycarbonyl group (preferably having 6 to 30 carbon atoms, more preferably having 6 to 15 carbon atoms, e.g., phenoxycarbonyl group or 1-naphthoxycarbonyl group),
alkylcarbonyloxy group (preferably having 2 to 30 carbon atom, more preferably having 2 to 15 carbon atoms, e.g., acetoxy group, propionyloxy group or butyroyloxy group),
arylcarbonyloxy group (preferably having 6 to 30 carbon atoms, more preferably having 6 to 15 carbon atoms, e.g., benzoyloxy group or 1-naphthoyloxy group),
urethane group (preferably having 1 to 30 carbon atoms, more preferably having 1 to 15 carbon atoms, e.g., methoxycarbonamide group, phenoxycarbonamide group or methylaminocarbonamide group),
ureide group (preferably having 1 to 30 carbon atoms, more preferably having 1 to 15 carbon atoms, e.g., methylaminocarbonamide group, dimethylaminocarbonamide group or diphenylaminocarbonamide group),
carbonic acid ester group (preferably having 1 to 30 carbon atoms, more preferably having 1 to 15 carbon atoms, e.g., methoxycarbonyloxy group or phenoxycarbonyloxy group), and
silyl group (preferably having 1 to 30 carbon atoms, more preferably having 1 to 15 carbon atoms, e.g., trimethylsilyl group, triphenylsilyl group or triethylsilyl group).

R² and R³ are each preferably an alkyl group among them, or R² and R³ are preferably bonded to form an aromatic ring.

In the formula (1), R⁴ is a hydrogen atom, or a substituted or unsubstituted
alkyl group (preferably having 1 to 30 carbon atoms, more preferably having 1 to 15 carbon atoms, e.g., methyl group, t-butyl group or cyclohexyl group),
alkenyl group (preferably having 2 to 30 carbon atom, more preferably having 2 to 15 carbon atoms, e.g., vinyl group, 1-propenyl group, 1-buten-2-yl group or cyclohexen-1-yl group),
alkynyl group (preferably having 2 to 30 carbon atom, more preferably having 2 to 15 carbon atoms, e.g., ethynyl group or 1-propynyl group),
aryl group (preferably having 6 to 30 carbon atom, more preferably having 6 to 15 carbon atoms, e.g., phenyl group, tolyl group, xylyl group, naphthyl group, biphenylyl group or pyrenyl group),
heterocyclic group (preferably having 2 to 30 carbon atom, more preferably having 2 to 15 carbon atoms; it preferably has a five-or six-membered ring structure and may be condensed with another ring, and the hetero atom may be nitrogen atom, oxygen atom, sulfur atom or the like; e.g., pyridyl group, piperidyl group, oxazolyl group, oxadiazolyl group, tetrahydrofuryl group or thienyl group),
alkylcarbonyl group (preferably having 2 to 30 carbon atoms, more preferably having 2 to 15 carbon atoms, e.g., acetyl group, propionyl group, butyroyl group or lauroyl group),
arylcarbonyl group (preferably having 6 to 30 carbon atoms, more preferably having 6 to 15 carbon atoms, e.g., benzoyl group or naphthoyl group),
alkylsulfonyl group (preferably having 1 to 30 carbon atoms, more preferably having 1 to 15 carbon atoms, e.g., methanesulfonyl group or ethanesulfonyl group),
arylsulfonyl group (preferably having 6 to 30 carbon atoms, more preferably having 6 to 15 carbon atoms, e.g., benzenesulfonyl group, p-toluenesulfonyl group or 1-naphthalenesulfonyl group),
alkoxycarbonyl group (preferably having 2 to 30 carbon atom, more preferably having 2 to 15 carbon atoms, e.g., methoxycarbonyl group, ethoxycarbonyl group or butoxycarbonyl group),
aryloxycarbonyl group (preferably having 6 to 30 carbon atoms, more preferably having 6 to 15 carbon atoms, e.g., phenoxycarbonyl group or 1-naphthoxycarbonyl group),
carbamoyl group (preferably having 1 to 30 carbon atoms, more preferably having 1 to 15 carbon atoms, e.g., unsubstituted carbamoyl group, methylcarbamoyl group, dimethylcarbamoyl group, phenylcarbamoyl group, diphenylcarbamoyl group or dioctylcarbamoyl group), or
sulfamoyl group (preferably having 1 to 30 carbon atoms, more preferably having 1 to 15 carbon atoms, e. g. , unsubstituted sulfamoyl group, methylsulfamoyl group, dimethylsulfamoyl group, phenylsulfamoyl group, diphenylsulfamoyl group or dioctylsulfamoyl group).

In the formula (1), Z is an atomic group that forms an aromatic ring. The aromatic ring formed from Z may contain a hetero atom. The aromatic ring formed from Z is preferably a benzene ring, a naphthalene ring, an anthracene ring, a pyridine ring or a pyrazine ring, and is more preferably a benzene ring.

R² and R³, and Z may further have a substituent group. Examples of the substituent groups include the aforesaid groups given as examples of R² and R³

In the formula (1), X is a divalent linkage group. It is thought that by the presence of X, a proper distance is given between the polymer main chain and the specific pyrrole derivative structure, and therefore, the organic light-emitting element containing the high-molecular compound represented by the formula (1) in the organic layer exhibits high maximum luminance and high external quantum efficiency and also has excellent durability.

X is preferably an alkylene group, an arylene group or a divalent aromatic heterocyclic group, and is more preferably an arylene group. It is thought that when X is any one of these groups, durability of the organic light-emitting element containing the high-molecular compound represented by the formula (1) in the organic layer can be much more enhanced as compared with the case where X is another divalent group (e.g., -COO- or -CONH-).

Examples of the linkage groups represented by X include the following groups.

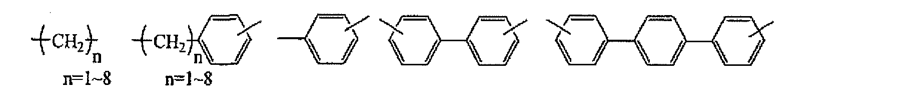

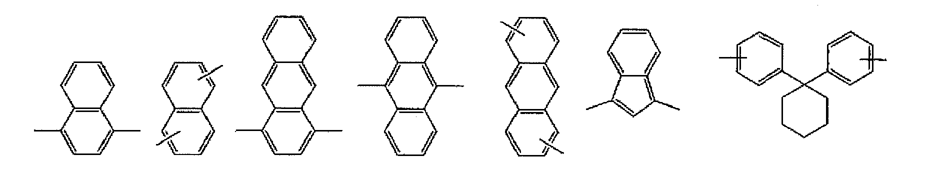

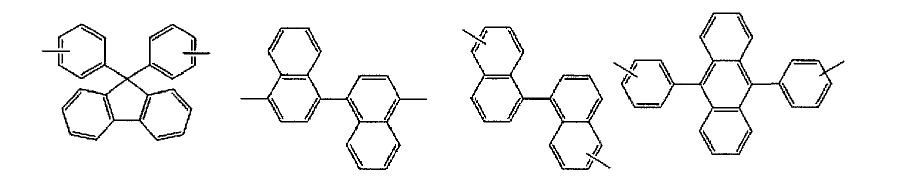

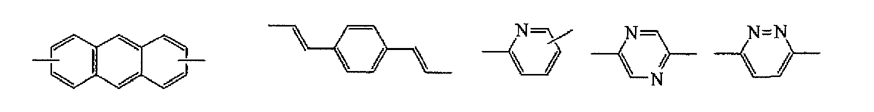

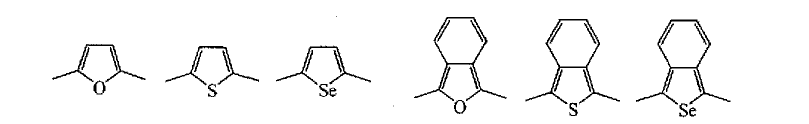

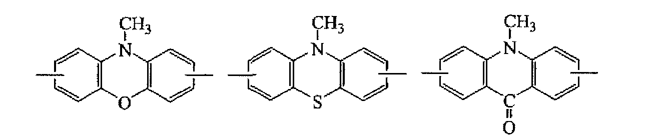

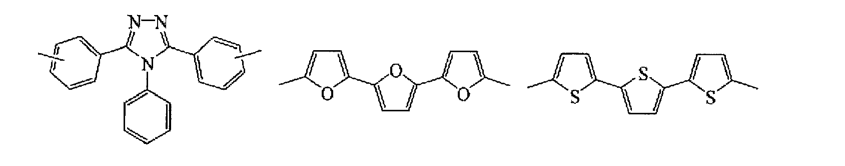

In the formula (1), A represents a copolymerized monomer unit derived from a vinyl monomer. k (% by mol) is a number satisfying the condition of 0<k≤100, preferably 10≤k≤100, more preferably 30≤k≤100, and n (% by mol) is a number satisfying the condition of 0≤n≤100, preferably 0≤n≤90, more preferably 0≤n≤70, and the sum of k and n is 100. That is to say, the organic light-emitting element material of the present invention which is a high-molecular compound represented by the formula (1) may be a copolymer having a copolymerized monomer unit that is represented by A and derived from a vinyl monomer or may be a homopolymer that does not have it. The copolymer may be a random copolymer or may be a block copolymer. As the vinyl monomer for deriving the copolymerized monomer unit represented by A, any of various vinyl monomers is employable. These monomers maybe used singly or in combination of plural kinds. Examples of the vinyl monomers include styrene, α-methylstyrene, butadiene, vinyl acetate, acrylic acid, methacrylic acid, acrylic acid ester, methacrylic acid ester, acrylamide, methacrylamide and monomers wherein various functional groups are bonded to them.

In the high-molecular compound represented by the formula (1), it is extremely preferable that the pyrrole ring, R², R³ and Z form a carbazole ring. That is to say, the high-molecular compound which is the organic light-emitting element material of the present invention is preferably represented by the following formula (2).

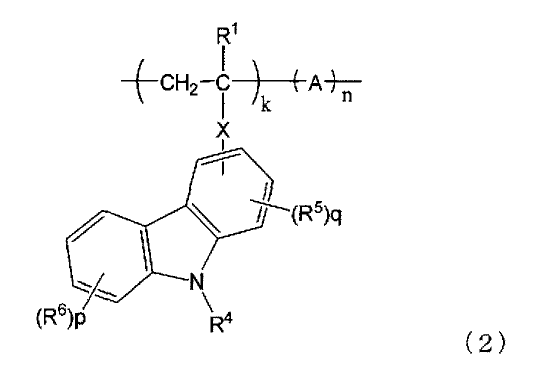

R¹, R⁴, X, A, k and n in the formula (2) have the same meanings as those of them in the formula (1), and preferred embodiments thereof are the same as those given for them. R⁵ and R⁶ are each independently a substituent group, and examples thereof include the same groups as the examples of the substituent groups of the aforesaid R², R³ and Z. p is an integer of 0 to 4, and q is an integer of 0 to 3.

The high-molecular compound which is the organic light-emitting element material of the present invention can be obtained by polymerizing vinyl monomers for deriving the respective constitutional units in the high-molecular compound by general radical polymerization process or ionic polymerization process. Above all, radical polymerization process and cationic polymerization process are preferably used. Details of these polymerization processes are described in "Experimental Methods for Polymer Syntheses", written by Otsu and Kinoshita, ed. by Kagaku-Dojin Publishing Company, INC. (1972). The weight-average molecular weight (Mw) of the high-molecular compound to constitute the organic light-emitting element material of the present invention is usually in the range of 1,000 to 10,000,000, preferably 2,000 to 1,000,000, particularly preferably 5,000 to 500,000.

Although the organic light-emitting element material of the present invention can be used as any of a hole injection material, a hole transporting material, a luminescent material, an electron transporting material and an electron injection material, it can be preferably used as a hole injection material, a hole transporting material or a luminescent material. The organic light-emitting element material of the present invention may be used singly, or may be used in combination with another organic material or inorganic material. The organic material used in combination may be a low-molecular organic material or may be a high-molecular organic material. Examples of the low-molecular organic materials include triphenylamine derivatives, such as TPD (N,N'-dimethyl-N,N'-(3-methylphenyl)-1,1'-biphenyl-4,4'-diamine), α-NPD (4,4'-bis[N-(1-naphthyl)-N-phenylamino]biphenyl) and m-MTDATA (4,4',4"-tris(3-methylphenylphenylamino)triphenylamine), carbazole derivatives, such as N-phenylcarbazole and 4,4'-carbazolylbiphenyl, and phenylborane derivatives, such as trimesitylborane. Examples of the high-molecular organic materials include high-molecular compounds obtained by introducing polymerizable functional groups into the above triphenylamine derivatives and polymerizing them, and luminescent high-molecular compounds, such as polyparaphenylene vinylidene and polydialkylfluorene. Examples of the inorganic materials include p-type Si and p-type SiC. The organic light-emitting element material may be used by laminating it and another high-molecular organic material upon each other. Moreover, the organic light-emitting element material may be used by mixing it with a low-molecular compound or laminating it and a low-molecular compound upon each other. In this case, the low-molecular compound may be mixed with a polymer binder and then applied, and may be laminated by vacuum deposition, sputtering or the like. Examples of the high-molecular compounds which are the organic light-emitting element materials of the present invention are given below.

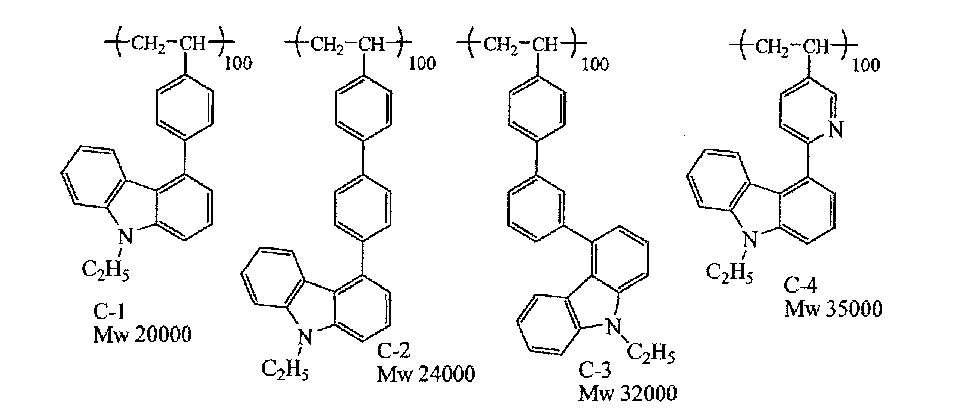

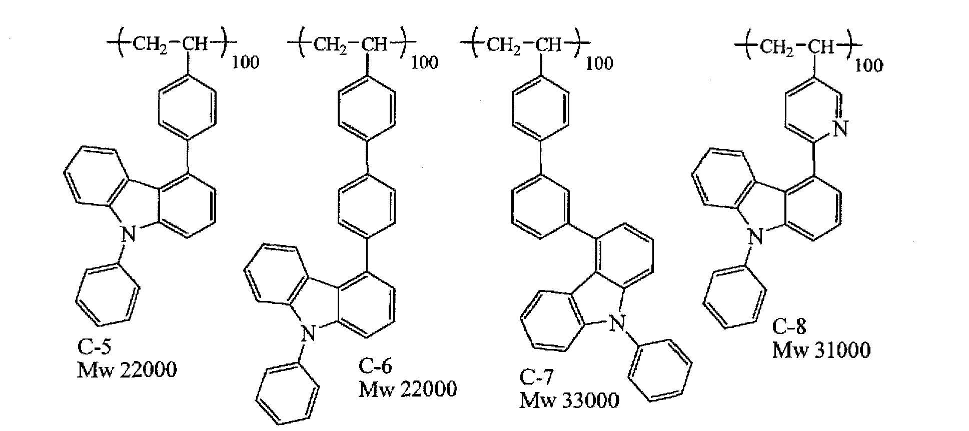

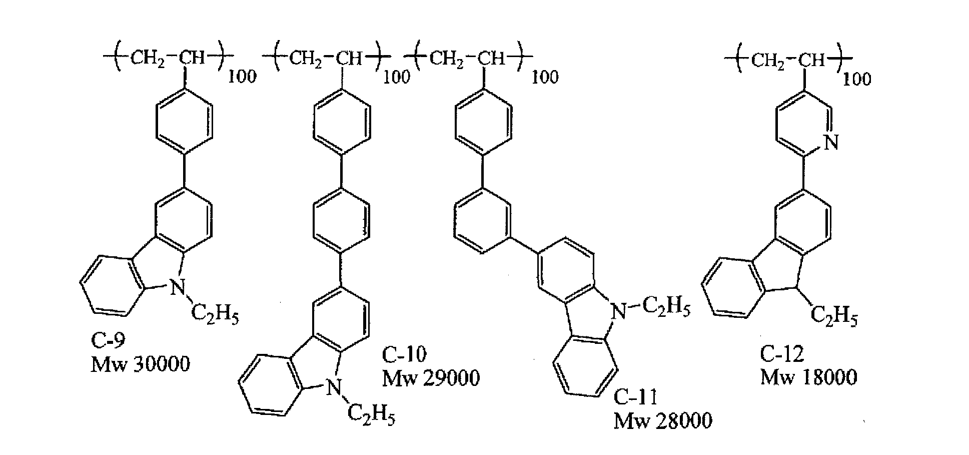

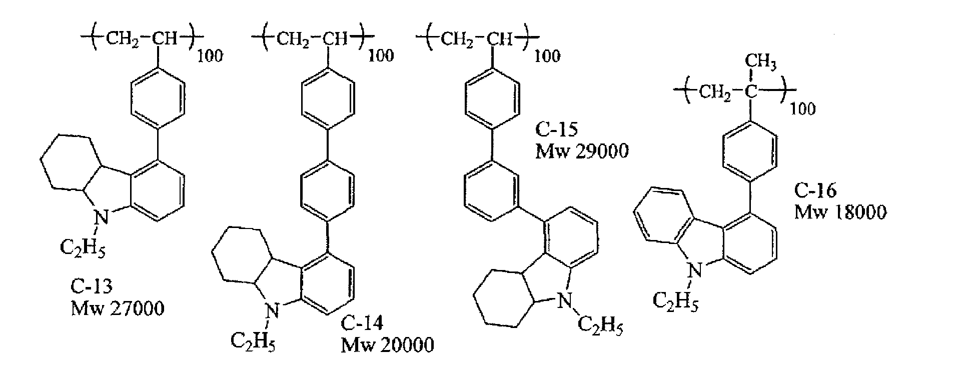

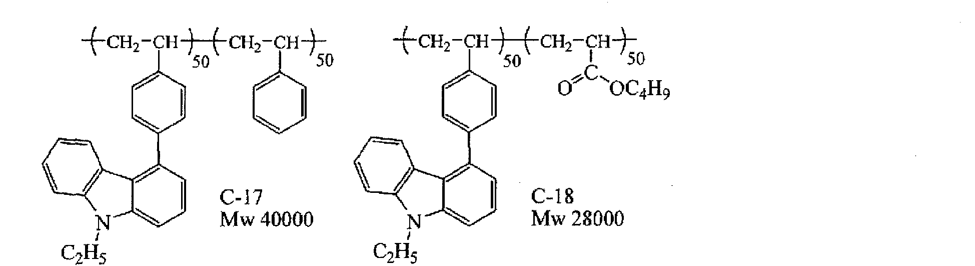

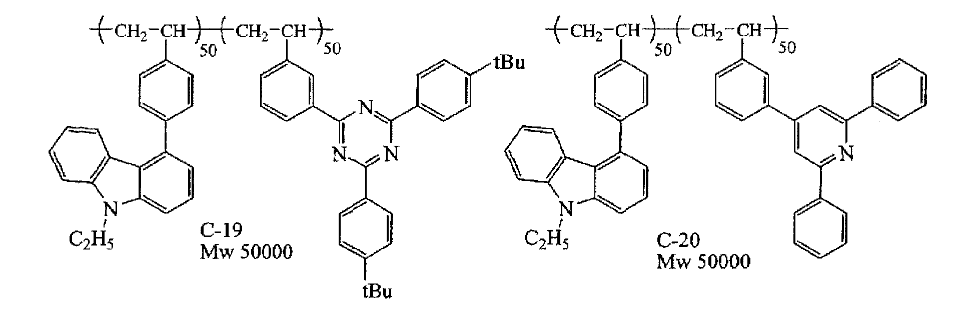

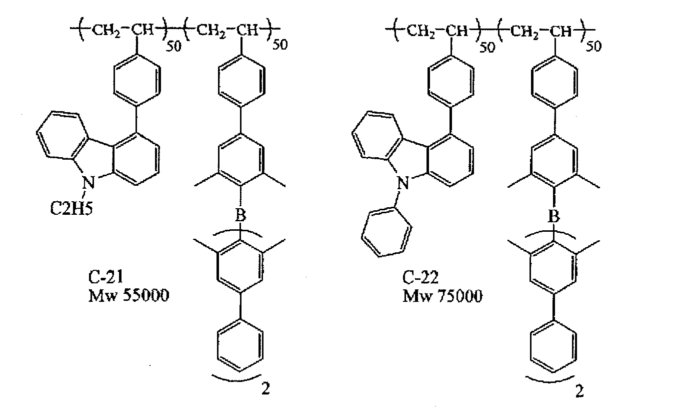

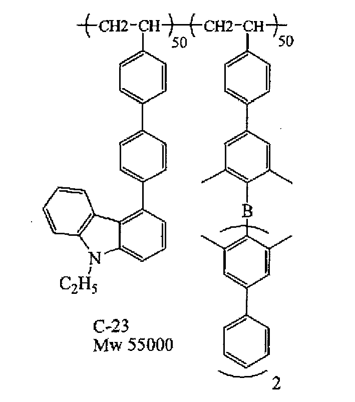

### [2] Organic light-emitting element

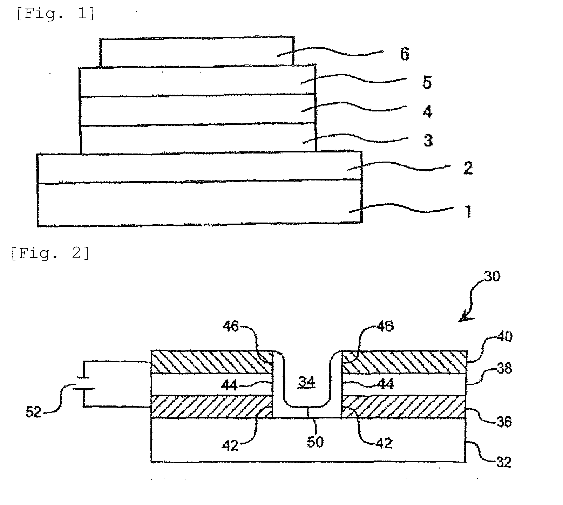

As the organic light-emitting element of the present invention, there can be mentioned such an organic light-emitting element having an organic layer between a pair of electrodes (anode 2 and cathode 6) as shown in Fig. 1. The organic layer is a luminescent layer 4 or consists of plural organic compound thin film layers including the luminescent layer 4. At least one of the organic layers contains the aforesaid organic light-emitting element material of the present invention.

As the organic light-emitting element of the present invention, there can be also mentioned such an organic light-emitting element as describedinapatent literature WO01/06577, namely, such an organic light-emitting element as shown in Fig. 2, which is an organic light-emitting element (organic light-emitting element with cavity) having a hole injection electrode layer 36, an electron injection electrode layer 40 and a dielectric layer 38 interposed between the hole injection electrode layer 36 and the electron injection electrode layer 40, and having a cavity 34 which extends through at least one of these electrode layers and the dielectric layer 38 and has an internal cavity surface provided with a hole injection electrode region 42, an electron injection electrode region 46 and a dielectric region 44, wherein an organic layer 50 containing the aforesaid organic light-emitting element material of the present invention is in electrical contact with the hole injection electrode region 42 and the electron injection electrode region 46 on the internal cavity surface.

The process for producing the former organic light-emitting element is a process for producing an organic light-emitting element having an organic layer between a pair of electrodes, and comprises a step of forming the organic layer comprising the organic light-emitting element material of the present invention on one of the electrodes and a step of forming the other of the electrodes on the organic layer.

The latter organic light-emitting element can be produced by such a production process as described in a patent literature WO 01/06577, namely, a production process comprising a step of forming a laminated structure having a hole injection electrode layer 36, an electron injection electrode layer 40 and a dielectric layer 38 interposed between the hole injection electrode layer 36 and the electron injection electrode layer 40 and having a cavity 34 which extends through at least one of these electrode layers and the dielectric layer 38 and has an internal cavity surface provided with a hole injection electrode region 42, an electron injection electrode region 46 and a dielectric region 44, and a step of forming an organic layer 50 containing the aforesaid organic light-emitting element material of the present invention on the internal cavity surface in such a manner that the organic layer 50 comes into electrical contact with the hole injection electrode region 42 and the electron injection electrode region 46 on the internal cavity surface.

Themethod for forming the organic layer comprising the organic light-emitting element material of the present invention is, for example, a coating method or an ink jet method.

The organic layers may include a hole injection layer, an electron injection layer, a protective layer, etc., and these layers may be each a layer having other functions. As previously described, the organic light-emitting element material of the present invention may be contained in any of these layers, and is preferably contained in the hole injection layer, the hole transport layer or the luminescent layer. At least one of the organic layers is preferably formed by a coating method.

These layers are described in detail hereinafter taking the case of the former organic light-emitting element as an example.

### Constitution of organic light-emitting element

An example of constitution of the organic light-emitting element of the present invention is shown in Fig. 1, but the constitution of the organic light-emitting element of the present invention is not limited to this. In Fig. 1, between an anode 2 provided on a transparent substrate 1 and a cathode 6, a hole transport layer 3, a luminescent layer 4 and an electron transport layer 5 are provided in this order. In this organic light-emitting element, for example, any one of (1) hole transport layer/luminescent layer and (2) luminescent layer/electron transport layer may be provided between the anode 2 and the cathode 6. Further, any one of (3) a layer containing a hole transporting material, a luminescent material and an electron transporting material, (4) a layer containing a hole transporting material and a luminescent material, (5) a layer containing a luminescent material and an electron transporting material and (6) the luminescent layer may be provided. Moreover, two or more luminescent layers may be laminated. Between the anode 2 and the luminescent layer 4, a hole injection layer may be provided, or between the luminescent layer 4 and the cathode 6, an electron injection layer may be provided.

### (a) Anode

The anode supplies holes to the hole injection layer, the hole transport layer, the luminescent layer or the like. As the material for forming the anode, a metal, an alloy, a metal oxide, an electrically conductive compound, a mixture of them, or the like is employable, and a material having a work function of not less than 4 eV is preferably used. Examples of such materials include metals (gold, silver, chromium, nickel, etc.), conductive metal oxides (tin oxide, zinc oxide, indium oxide, ITO (indium tin oxide), etc.), mixtures or laminates of these metals and conductive metal oxides, inorganic conductive substances (copper iodide, copper sulfide, etc.), organic conductive materials(polyaniline,polythiophene,polypyrrole,etc.), and laminates of these materials and ITO. The anode is preferably composed of a conductive metal oxide, and from the viewpoints of productivity, high conduction properties, transparency, etc., ITO is particularly preferable.

The method to form the anode is properly selected according to the material used, and in the case of for example ITO, electron beam method, sputtering method, resistance heating deposition method, chemical reaction method (sol-gel method or the like), application of indium tin oxide dispersion, etc. can be used. It is also possible to lower the voltage for driving the organic light-emitting element or to raise the luminous efficiency by subjecting the anode to washing treatment or the like. In the case of for example an anode composed of ITO, UV-ozone treatment, plasma treatment or the like is effective. The sheet resistance of the anode is preferably not more than several hundred Ω/□. Although the film thickness of the anode can be properly selected according to the material, it is preferably in the range of 10 nm to 5 µm, more preferably 50 nm to 1 µm, particularly preferably 100 nm to 500 nm.

The anode is usually formed on a substrate made of soda lime glass, non-alkali glass, transparent resin or the like. In the case of a glass substrate, non-alkali glass is preferably used in order to reduce the amount of elution ions from the glass. When soda lime glass is used, it is preferable to subject the surface of the glass to barrier coat treatment with silica or the like in advance. The thickness of the substrate is not specifically restricted provided that the thickness is sufficient to maintain mechanical strength, but in the case of a glass substrate, the thickness of the substrate is usually not less than 0.2 mm, preferably not less than 0.7 mm.

### (b) Cathode

The cathode supplies electrons to the electron injection layer, the electron transport layer, the luminescent layer or the like. As the material of the cathode, a metal, an alloy, a metal halide, a metal oxide, an electrically conductive compound, a mixture of them, or the like is employable, and it is good to select the material taking into account adhesion to the adjacent layer such as a luminescent layer, ionization potential, stability, etc. Examples of the materials include alkali metals (Li, Na, K, Cs, etc.) and fluorides thereof, alkaline earth metals (Mg, Ca, etc.) and fluorides thereof, gold, silver, lead, aluminum, a sodium-potassium alloy, a lithium-aluminum alloy, a magnesium-silver alloy and mixed metals thereof, andrareearthmetals (indium, ytterbium, etc.). The cathode is preferably composed of a material having a work function of not more than 4 eV, and is more preferably composed of aluminum, a lithium-aluminum alloy, a magnesium-silver alloy or mixed metals thereof.

The cathode may have a single-layer structure formed from such a material as above or may have a laminated structure including a layer formed from the above material. The cathode can be formed by electron beam method, sputtering method, resistance heating deposition method, coating method, or the like. In the case of the deposition method, the material may be deposited alone, or two or more kinds of the materials may be deposited at the same time. When an alloy electrode is formed, it is possible to formitby depositing plural kinds of metals at the same time, or an alloy prepared in advance may be deposited. The sheet resistance of the cathode is preferably not more than several hundred Ω/□. Although the film thickness of the cathode can be properly selected according to the material, it is preferably in the range of 10 nm to 5 µm, more preferably 50 nm to 1 µm, particularly preferably 100 nm to 1 µm.

### (c) Hole injection layer and hole transport layer

The material used for the hole injection layer and the hole transport layer has only to be a material having any one of a function to inject holes from the anode, a function to transport holes and a function to constitute a barrier against electrons injected from the cathode. Examples of such materials include conductive high-molecular substances, such as carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne-based compounds, porphyrin-based compounds, polysilane-based compounds, poly(N-vinylcarbazole) derivatives, aniline-based copolymers, thiophene oligomers and polythiophene.

The hole injection layer and the hole transport layer may have a single-layer structure formed from one or more kinds of the above materials, or may have a multi-layer structure consisting of plural layers of the same compositions or different compositions. For forming the hole injection layer and the hole transport layer, vacuum deposition method, LB method, ink jet method, method comprising dissolving or dispersing the above material in a solvent and applying the resulting coating liquid (spin coating, casting, dip coating or the like), etc. are used. In the case of the application method, the coating liquid may be prepared by dissolving or dispersing the above material together with a resin component. As the resin component, polyvinyl chloride, polycarbonate, polystyrene, polymethyl methacrylate, polybutyl methacrylate, polyester, polysulfone, polyphenylene oxide, polybutadiene, poly(N-vinylcarbazole), hydrocarbon resin, ketone resin, phenoxy resin, polyamide, ethyl cellulose, polyvinyl acetate, ABS resin, polyurethane, melamine resin, unsaturated polyester resin, alkyd resin, epoxy resin, silicon resin or the like can be used. Although the film thickness of each of the hole injection layer and the hole transport layer is not specifically restricted, it is, generally, preferably in the range of 1 nm to 5 µm, more preferably 5 nm to 1 µm, particularly preferably 10 nm to 500 nm.

### (d) Luminescent layer

When an electric field is applied to the organic light-emitting element, holes injected from the anode, the hole injection layer or the hole transport layer and electrons injected from the cathode, the electron injection layer or the electron transport layer are recombined with each other in the luminescent layer, whereby light is emitted. As materials to form the luminescent layer, the aforesaid light-emitting element materials can be preferably used, and in addition, benzoxazole derivatives, benzimidazole derivatives, benzothiazole derivatives, styrylbenzene derivatives, polyphenyl derivatives, diphenylbutadiene derivatives, tetraphenylbutadiene derivatives, naphthalimide derivatives, coumarin derivatives, perylene derivatives, perinone derivatives, oxaziazole derivatives, aldazine derivatives, pyralidine derivatives, cyclopentadiene derivatives, bis(styryl)anthracene derivatives, quinacridone derivatives, pyrrolopyridine derivatives, thiadiazolopyridine derivatives, styrylamine derivatives, aromatic dimethylidyne compounds, metal complexes (metal complex of 8-quinolinol derivative, rare earth complex, etc.), high-molecular luminescent materials (polythiophene, polyphenylene, polyphenylene vinylene and the like), etc. can be used.

The luminescent materials include a luminescent material that exhibits light emission from a singlet exciton, a luminescent material that exhibits light emission from a triplet exciton and a luminescent material that exhibits light emission from both of them, and in the organic light-emitting element of the present invention, any of these luminescent materials is employable. When the organic light-emitting element material of the present invention is used for the luminescent layer, it is particularly preferable to use it in combination with a luminescent material capable of light emission from a triplet exciton, because the effect of the organic light-emitting element material is much more exerted. As the luminescent material capable of light emission from a triplet exciton, an iridium complex Ir(ppy)₃ (tris-ortho-metalated complex of iridium(III) with2-phenylpyridine) is known. Agreenlight-emitting element using Ir(ppy)₃ has achieved an external quantum efficiency of 8%, and this exceeded an external quantum efficiency of 5% that was said to be a limit of external quantum efficiency of conventional organic light-emitting elements (Applied Physics Letters 75,4 (1999)). The method for forming the luminescent layer is not specifically restricted, and resistance heating deposition method, electron beam method, sputtering method, molecular lamination method, coating method (spin coating, casting, dip coating or the like), LB method, ink jet method, etc. are employable. Of these, resistance heating deposition method and coating method are preferable. Although the film thickness of the luminescent layer is not specifically restricted, it is, generally, preferably in the range of 1 nm to 5 µm, more preferably 5 nm to 1 µm, particularly preferably 10 nm to 500 nm.

### (e) Electron injection layer and electron transport layer

The material for forming the electron injection layer and the electron transport layer has only to be a material having any one of a function to inject electrons from the anode, a function to transport electrons and a function to constitute a barrier against holes injected from the anode. Examples of such materials include triazole derivatives,oxazole derivatives,oxadiazole derivatives,fluorenone derivatives, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, heterocyclic tetracarboxylic anhydrides such as naphthaleneperylene, phthalocyanine derivatives, metal complexes (metal complex of 8-quinolinol derivative, metal complex having metal phthalocyanine, benzoxazole or benzothiazole as a ligand, etc.).

The electron injection layer and the electron transport layer may have a single-layer structure formed from one ormore kinds of the abovematerials, ormayhave amulti-layer structure consisting of plural layers of the same compositions or different compositions. For forming the electron injection layer and the electron transport layer, vacuum deposition method, LB method, ink jet method, method comprising dissolving or dispersing the above material in a solvent and applying the resulting coating liquid (spin coating, casting, dip coating or the like), etc. are used. In the case of the application method, the coating liquid may be prepared by dissolving or dispersing the above material together with a resin component. As the resin components, the same resin components as those for the aforesaid hole injection layer and hole transport layer can be used. Although the film thickness of each of the electron injection layer and the electron transport layer is not specifically restricted, it is, generally, preferably in the range of 1 nm to 5 µm, more preferably 5 nm to 1 µm, particularly preferably 10 nm to 500 nm.

### (f) Protective layer

The protective layer has a function to inhibit substances that accelerate deterioration of element, such as water and oxygen, from being introduced into the element. As materials of the protective film, metals (In, Sn, Pb, Au, Cu, Ag, Al, Ti, Ni, etc.), metal oxides (MgO, SiO, SiO₂, Al₂O₃, GeO, NiO, CaO, BaO, Fe₂O₃, Y₂O₃, TiO₂ etc.), metal fluorides (MgF₂, LiF, AlF₃, CaF₂, etc.), polyethylene, polypropylene, polymethylmethacrylate, polyimide, polyurea, polytetrafluoroethylene, polychlorotrifluoroethylene, polydichlorodifluoroethylene, a copolymer of chlorotrifluoroethylene and dichlorodifluoroethylene, a copolymer obtained by copolymerizing a monomer mixture containing tetrafluoroethylene and at least one comonomer, a fluorine-containing copolymer having a cyclic structure in the copolymer main chain, a water absorbing substance having a water absorption ratio of not less than 1%, a moistureproof substance having a water absorption ratio of not more than 0.1%, etc. can be used.

The method for forming the protective layer is not specifically restricted,and vacuum deposition method,sputtering method, reactive sputtering method, MBE (molecular beam epitaxy) method, cluster ion beam method, ion plating method, plasma polymerization method (high-frequency excitation ion plating method), plasma CVD method, laser CVD method, heat CVD method, gas source CVD method, coating method, ink jet method, etc. are applicable.

### [4] Uses

The organic light-emitting element of the present invention is favorably used as a picture element on a matrix system or a segment system in an image display device in a publicly known way. Further, the organic light-emitting element is favorably used also as a light emission surface light source without forming a picture element.

More specifically, the organic light-emitting element of the present invention is favorably used for display devices, such as computer, television, portable terminal, cellular phone, car navigation and view finder of video camera, back light, electrophotography, illumination light source, recording light source, exposure light source, read light source, marking, signboard, interior accessory, and optical communication system.

### Examples

The present invention is further described with reference to the following examples, but it should be construed that the present invention is in no way limited to those examples.

### 1. Synthesis of organic light-emitting element material

The "polymer C-1" in the following Table 1 means a high-molecular compound represented by the aforesaid formula (C-1), and the same shall apply to other materials. Structures of the polymers C-24 to C-27 are as described later.

These polymers were prepared by polymerizing raw material monomers by a hitherto publicly known process. The preparation process is described below in detail taking synthesis of the polymer C-5 as an example.

### ] Synthesis of polymer C-5

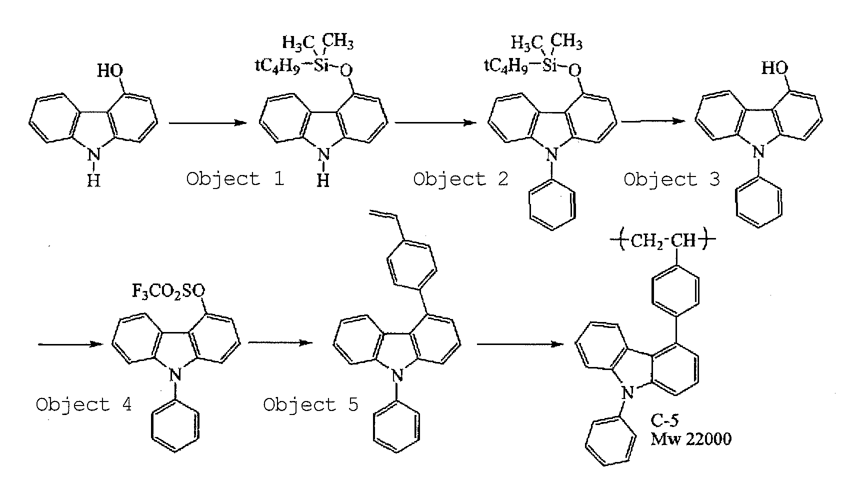

### Synthesis of object 1

In a 500 ml three neck flask equipped with a thermometer and a reflux condenser, 18.32 g (0.1 mol) of 4-hydroxycarbazole, 15.80 g (0.105 mol) of tert-butyldimethylchlorosilane, 100 ml of dichloromethane and 10 ml of N,N-dimethylformamide were placed, then a stream of nitrogen gas was passed through the flask, and the contents were stirred using a magnetic stirrer. To this mixture, 7.15g (0.105 mol) of imidazole was slowly added, and they were stirred for 2 hours at room temperature. After the stirring, the reaction mixture was filtered, and the insolubles were washed with dichloromethane. The filtrate was concentrated, and to the concentrate were added 150 ml of ethyl acetate and 100 ml of water. Then, liquid separation operation was carried out, and the organic layer was extracted and concentrated. The residue was purified by silica gel column chromatography (elution solvent: hexane/dichloromethane = 1/3) to obtain an object 1 (25.2 g).

### Synthesis of object 2

In a 300 ml three neck flask equipped with a cooling tube, 25.2 g (85 mmol) of the object 1, 200 ml of toluene, 35.2 g (255 mmol) of potassium carbonate and20. 4 g (100 mmol) of iodobenzene were placed, and they were heated and stirred at 110°C for 30 minutes. To this mixture were added 763 mg (3.4 mmol) of palladium acetate and 2.0 g (10 mmol) of tri-tert-butylphosphine, and they were stirred at 110°C for 6 hours. After the reaction, the insolubles were filtered away, and to the filtrate was added 100 ml of water. Then, liquid separation operation was carried out, and the organic layer was extracted and concentrated. The residue was purified by silica gel column chromatography (elution solvent: hexane/dichloromethane = 3/1) to obtain an object 2 (23.8 g).

### Synthesis of object 3

In a 500 ml recovery flask, 23.8 g (64 mmol) of the object 2 and 200 ml of tetrahydrofuran were placed, and they were stirred at room temperature. To this mixture was added 40.32 g (128 mmol) of tetrabutylammonium fluoride hydrate, and they were stirred for 1 hour at room temperature. After the reaction, 200 ml of a 5% citric acid aqueous solution was added, and THF was distilled off by an evaporator. To the residue was added ethyl acetate, then liquid separation operation was carried out, and the organic layer was extracted and concentrated to obtain an object 3 (16.3 g).

### Synthesis of object 4

In a 300 ml recovery flask, 16.3 g (63 mmol) of the object 3 and 100 ml of pyridine were placed, and they were stirred with ice cooling. To this mixture was added 19.8 g (70 mmol) of trifluoromethanesulfonic anhydride, and they were stirred for 2 hours at the same temperature. The reaction mixture was poured onto ice and stirred for 10 minutes. Thereafter, ethyl acetate was added. Then, liquid separation operation was carried out, and the organic layer was extracted and concentrated. The residue was purified by silica gel column chromatography (elution solvent:
hexane/dichloromethane = 3/1) to obtain an object 4 (22.2 g).

### Synthesis of object 5

In a 500 ml three neck flask equipped with a thermometer and a reflux condenser, 22.0 g (56 mmol) of the object 4, 9.62 g (65 mmol) of p-vinylphenylboric acid, 23.2 g (168 mmol) of potassium carbonate, 100 mg of 2,6-di-tert-butyl-p-cresol, 100 ml of toluene and 60 ml of water were placed, and they were stirred at 110°C for 1 hour in a stream of nitrogen. To this reaction mixture was added 3. 76 g (3.25 mmol) of tetrakis(triphenylphosphine)palladium(O), and they were stirred at 110°C for 4 hours in a stream of nitrogen. After the reaction, the insolubles were filtered, then the filtrate was subj ected to liquid separation operation, and the organic layer was extracted and concentrated. The residue was purified by silica gel column chromatography (elution solvent: hexane/dichloromethane = 2/1) to obtain an object 5 (14.5 g).

### Synthesis of polymer C-5

In a 100 ml three neck flask which had been equipped with a thermometer and a reflux condenser and the interior of which had been dried by passing a stream of dry nitrogen, 2 g of the object 5 and 20 ml of toluene were placed, then they were stirred by a magnetic stirrer to completely dissolve the object 5, and 20 mg of 2,2'-azobis(N-butyl-2-methylpropionamide) was further added as an initiator. Through this mixture, nitrogen was bubbled to expel dissolved oxygen, and then the mixture was refluxed at 110°C for 3 hours with stirring. Subsequently,the resulting mixture wasdropwise added to 1 liter of acetone to precipitate solids. The solids were filtered off, washed with acetone and then vacuum dried in a desiccator to obtain 1.8 g of a polymer C-5. The weight-average molecular weight (Mw) of the resulting polymer C-5 was 20, 000 in terms of polystyrene. The weight-average molecular weight was measured by gel permeation chromatography.

### 2. Manufacture and evaluation of organic light-emitting elements

### Example 1 (Manufacture and evaluation of organic EL elements 1)

Using a substrate with ITO (Nippo Electric Co., Ltd.) in which two ITO (indium tin oxide) electrodes each having a width of 4 mm that would become anodes had been formed in stripes on one surface of a glass substrate of 25 mm × 25 mm, organic EL elements 1 were fabricated.

First, on ITO (anodes) of the substrate with ITO, poly(3,4-ethylenedioxythiophene)-polystyrenesulfonic acid (available from Bayer, trade name "Baytron P") was applied by spin coating under the conditions of a rotation speed of 3,500 rpm and a coating time of 40 seconds, and then the coating layer was dried by a vacuum dryer at 60°C for 2 hours under reduced pressure to form an anode buffer layer. The film thickness of the resulting anode buffer layer was about 50 nm.

Next, a coating solution for forming a layer containing an emitting compound and a carrier transporting compound was prepared. The polymer C-1 (45 mg), a compound represented by the following formula (E-2) (45 mg) and an iridium complex Ir(ppy)₃ (tris-ortho-metalated complex of iridium(III)with2-phenylpyridine) (10 mg) were dissolved in toluene (available from Wako Pure Chemical Industries, Ltd., specialgrade) (2, 910mg), and the resulting solution was filtered through a filter having a hole diameter of 0.2 µm to give a coating solution. Next, on the anode buffer layer, the thus prepared coating solution was applied by spin coating under the conditions of a rotation speed of 3,000 rpm and a coating time of 30 seconds, and the coating layer was dried at room temperature (25°C) for 30 minutes to form a luminescent layer. The film thickness of the resulting luminescent layer was about 100 nm.

The compound represented by E-2 was synthesized by polymerizing a compound represented by the following formula E-1 in the same manner as for the polymer C-5, said compound represented by the formula E-1 having been synthesized by the process described in a patent literature JP-A-2005-200638. The weight-average molecular weight (Mw) of this polymer E-2 was 50,000 in terms of polystyrene.

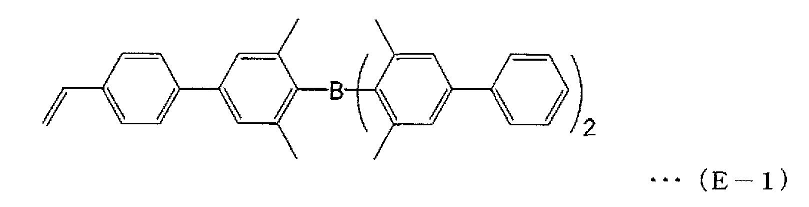

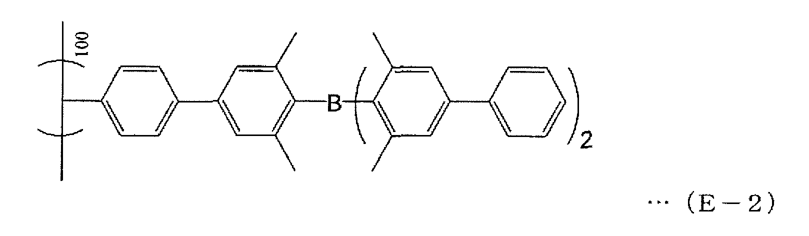

Next, the substrate on which the luminescent layer had been formed was placed in a deposition apparatus, then cesium was deposited in a thickness of 2 nm at a deposition rate of 0.01 nm/s (as cesium source, alkali metal dispenser manufactured by SAES Getters was used), and subsequently, aluminum was deposited as a cathode in a thickness of 250 nm at a deposition rate of 1 nm/s. The layers of cesium and aluminum were formed in two stripes each having a width of 3 mm and crossing at a right angle to the extending direction of the anode. Thus, four organic EL elements 1 each having a size of 4 mm (length) × 3 mm (width) were fabricated per one glass substrate.

Using a programmable direct-current voltage/current source TR6143 manufactured by Advantest Corporation, a voltage was applied to the organic EL elements 1 to allow them to emit light, and their luminance was measured by the use of a luminance meter BM-8 manufactured by Topcon Corporation. A light emission starting voltage, a maximum luminance and an external quantum efficiency at the time of lighting at 100 cd/m² obtained as results of the measurement are set forth in Table 2. Each value means a mean value of the four organic EL elements 1 formed in one substrate.

As for the organic El element 1, a driving life test was carried out under the following conditions to evaluate durability.

Temperature: room temperature
Driving system: direct-current driving
Initial luminance: 1000 cd/m²
The organic EL element 1 was allowed to emit light continuously at a constant current, and the period of time before the luminance became 50% (luminancehalf-valueperiod) wasmeasured. This luminance half-value period is expressed as a relative time given when the luminance half-value period of the later-described organic EL element fabricated in Comparative Example 1 is taken as 1.

### Examples 2 to 9 (Manufacture and evaluation of organic EL elements 2 to 9)

Organic EL elements 2 to 9 were fabricated and their luminance was measured in the same manner as in Example 1, except that organic light-emitting element materials and other materials described in Table 1 were used. A light emission starting voltage, a maximum luminance and an external quantum efficiency at the time of lighting at 100 cd/m² obtained as results of the measurement, and the result (durability) of a driving life test that was carried out in the same manner as in Example 1 are set forth in Table 2.

### Comparative Examples 1 to 4 (Manufacture and evaluation of organic EL elements 10 to 13)

Organic EL elements 10 to 13 were fabricated and their luminance was measured in the same manner as in Example 1, except that organic light-emitting element materials and other materials described in Table 1 were used. A light emission starting voltage, a maximum luminance and an external quantum efficiency at the time of lighting at 100 cd/m² obtained as results of the measurement, and the result (durability) of a driving life test that was carried out in the same manner as in Example 1 are set forth in Table 2.

### Example 10 (Manufacture and evaluation of organic EL elements 14)

A substrate having a cavity with a depth of 0.2 to 0.4 µm and a diameter of 6 µm was prepared in the same manner as in Example 1 described in a patent literature WO 01/06577.

Next, a coating solution was prepared in the same manner as in Example 1, except that an organic light-emitting element material and other materials described in Table 3 were used. Subsequently, the thus prepared coating solution was applied to the cavity side surface of the substrate and dried in the same manner as in Example 1 to form a luminescent layer (organic layer 50 in Fig. 2). Thus, organic EL elements 14 were fabricated.

As for the organic EL elements 14, the luminance was measured in the same manner as in Example 1. A light emission starting voltage, a maximum luminance and an external quantum efficiency at the time of lighting at 100 cd/m² obtained as results of the measurement are set forth in Table 4. The durability of the organic EL element 14 was evaluated in the same manner as in Example 1, except that instead of the luminance half-value period of the organic EL element fabricated in Comparative Example 1, the luminance half-value period of an organic EL element fabricated in Comparative Example 5 was taken as 1.

### Examples 11 to 13 (Manufacture and evaluation of organic EL elements 15 to 17)

Organic EL elements 15 to 17 were fabricated and their luminance was measured in the same manner as in Example 10, except that organic light-emitting element materials and other materials described in Table 3 were used. A light emission starting voltage, a maximum luminance and an external quantum efficiency at the time of lighting at 100 cd/m² obtained as results of the measurement, and the result (durability) of a driving life test that was carried out in the same manner as in Example 10 are set forth in Table 4.

### Comparative Examples 5 to 8 (Manufacture and evaluation of organic EL elements 18 to 21)

Organic EL elements 18 to 21 were fabricated and their luminance was measured in the same manner as in Example 10, except that organic light-emitting element materials and other materials described in Table 3 were used. A light emission starting voltage, a maximum luminance and an external quantum efficiency at the time of lighting at 100 cd/m² obtained as results of the measurement, and the result (durability) of a driving life test that was carried out in the same manner as in Example 10 are set forth in Table 4.

**Table 1**

| | Organic EL element | Organic light-emitting element material | Other materials |
|---|---|---|---|
| Examle 1 | 1 | Polymer C-1(45mg) | E-2(45mg) Ir(ppy)3(10mg) |
| Examle 2 | 2 | Polymer C-5(45mg) | E-2(45mg), Ir(ppy)3(10mg) |
| Examle 3 | 3 | Polymer C-9(45mg) | E-2(45mg), Ir(ppy)3(10mg) |
| Examle 4 | 4 | Polymer C-3(45mg) | E-2(45mg), Ir(ppy)3(10mg) |
| Examle 5 | 5 | Polymer C-13(45mg) | E-2(45mg), Ir(ppy)3(10mg) |
| Examle 6 | 6 | Polymer C-17(45mg) | E-2(45mg), Ir(ppy)3(10mg) |
| Examle 7 | 7 | Polymer C-21(90mg) | Ir(ppy)3(10mg) |
| Examle 8 | 8 | Polymer C-22 (90mg) | Ir (ppy) 3 (10mg) |
| Examle 9 | 9 | Polymer C-23(90mg) | Ir(ppy)3(10mg) |
| Comp.Ex.1 | 10 | Polymer C-24 (45mg) | E-2(45mg), Ir(ppy)3(10mg) |
| Comp.Ex.2 | 11 | Polymer C-25(45mg) | E-2(45mg), Ir(ppy)3(10mg) |
| Comp.Ex.3 | 12 | Polymer C-26(90mg) | Ir(ppy)3(10mg) |
| Comp.Ex.4 | 13 | Polymer C-27(90mg) | Ir(ppy)3(10mg) |

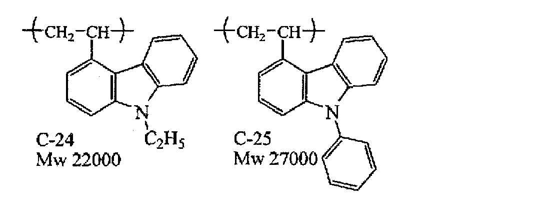

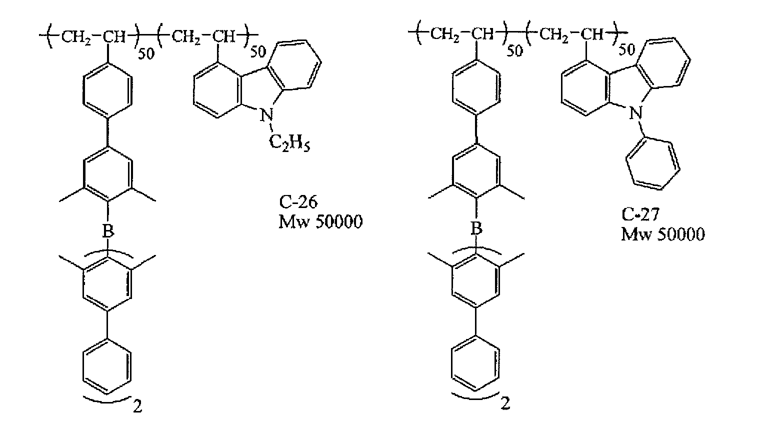

**Table 2**

| | Organic EL element | Light emission starting voltage (V) | Maximum luminance (cd/m²) | External quantum efficiency (%) | Durability |
|---|---|---|---|---|---|
| Examle 1 | 1 | 2.8 | 64000 | 8.2 | 2.18 |
| Examle 2 | 2 | 2.7 | 58000 | 7.2 | 2.00 |
| Examle 3 | 3 | 2.8 | 71000 | 7.9 | 2.40 |
| Examle 4 | 4 | 2.6 | 50000 | 6.1 | 2.20 |
| Examle 5 | 5 | 2.7 | 79000 | 6.1 | 1.88 |
| Examle 6 | 6 | 2.5 | 80000 | 6.6 | 3.60 |
| Examle 7 | 7 | 2.4 | 99000 | 9.2 | 5.02 |
| Examle 8 | 8 | 2.6 | 78000 | 8.5 | 4.55 |
| Examle 9 | 9 | 2.5 | 89000 | 8.8 | 4.88 |
| Comp.Ex.1 | 10 | 3.2 | 18000 | 3.9 | 1.00 |
| Comp.Ex.2 | 11 | 3.4 | 21000 | 3.2 | 0.95 |
| Comp.Ex.3 | 12 | 3.3 | 19000 | 3.7 | 1.30 |
| Comp.Ex.4 | 13 | 3.3 | 20000 | 3.5 | 1.20 |

It can be seen from Table 2 that the organic light-emitting elements 1 to 9 (Examples 1 to 9) using the organic light-emitting element materials of the present invention had higher maximum luminance and better external quantum efficiency as compared with the organic light-emitting elements 10 to 13 (Comparative Examples 1 to 4) using organic light-emitting element materials which were high-molecular compounds having no linkage group X. Moreover, it has become apparent that the durability was also improved.

**Table 3**

| | Organic EL element | Organic light-emitting element material | Other materials |
|---|---|---|---|
| Examle 10 | 14 | Polymer C-1(45mg) | E-2(45mg) Ir(ppy)3(10mg) |
| Examle 11 | 15 | Polymer C-5(45mg) | E-2(45mg), Ir(ppy)3(10mg) |
| Examle 12 | 16 | Polymer C-21(90mg) | Ir(ppy)3(10mg) |
| Examle 13 | 17 | Polymer C-22(90mg) | Ir(ppy)3(10mg) |
| Comp.Ex.5 | 18 | Polymer C-24(45mg) | E-2(45mg), Ir(ppy)3(10mg) |
| Comp.Ex.6 | 19 | Polymer C-25(45mg) | E-2(45mg), Ir(ppy)3(10mg) |
| Comp.Ex.7 | 20 | Polymer C-26(90mg) | Ir(ppy)3(10mg) |
| Comp.Ex.8 | 21 | Polymer C-27(90mg) | Ir(ppy)3(10mg) |

**Table 4**

| | Organic EL element | Light emission starting voltage (V) | Maximum luminance (cd/m²) | External quantum efficiency (%) | Durability |
|---|---|---|---|---|---|
| Examle 10 | 14 | 2.7 | 69000 | 12.2 | 2.88 |
| Examle 11 | 15 | 2.7 | 68000 | 10.2 | 2.39 |
| Examle 12 | 16 | 2.5 | 100000 | 13.2 | 4.99 |
| Examle 13 | 17 | 2.7 | 98000 | 12.5 | 4.78 |
| Comp.Ex.5 | 18 | 3.4 | 18000 | 4.6 | 1.00 |
| Comp.Ex.6 | 19 | 3.5 | 21000 | 4.0 | 0.95 |
| Comp.Ex.7 | 20 | 3.4 | 19000 | 4.6 | 1.30 |
| Comp.Ex.8 | 21 | 3.6 | 20000 | 4.4 | 1.20 |

It can be seen from Table 4 that the organic light-emitting elements 14 to 17 (Examples 10 to 13) using the organic light-emitting element materials of the present invention had higher maximum luminance and better external quantum efficiency as compared with the organic light-emitting elements 18 to 21 (Comparative Examples 5 to 8) using organic light-emitting element materials which were high-molecular compounds having no linkage group X. Moreover, it has become apparent that the durability was also improved.

### Reference Signs List

- 1:: substrate
- 2:: anode
- 3:: hole transport layer
- 4:: luminescent layer
- 5:: electron transport layer
- 6:: cathode
- 30:: organic light-emitting element
- 32:: substrate
- 34:: cavity
- 36:: hole injection electrode layer
- 38:: dielectric layer
- 40:: electron injection electrode layer
- 42:: hole injection electrode region
- 44:: dielectric region
- 46:: electron injection electrode region
- 50:: organic layer
- 52:: power source

## Claims

1. An organic light-emitting element material which is a high-molecular compound comprising k% by mol (0<k≤100) of a constitutional unit represented by the following formula (1a) and n% by mol (0≤n<100 and k+n=100) of a constitutional unit represented by the following formula (1b): 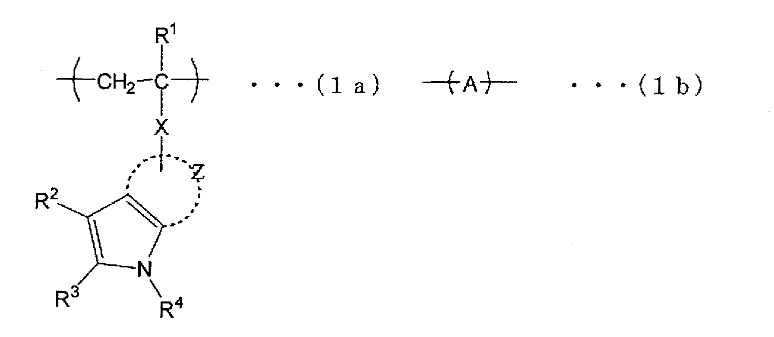 wherein R¹ is a hydrogen atom or a methyl group,
R² and R³ are each independently a hydrogen atom or a substituent group and may be bonded to each other to form a ring,
R⁴ is a hydrogen atom, or a substituted or unsubstituted alkyl group, alkenyl group, alkynyl group, aryl group, heterocyclic group, alkylcarbonyl group, arylcarbonyl group, alkylsulfonyl group, arylsulfonyl group, alkoxycarbonyl group, aryloxycarbonyl group, carbamoyl group or sulfamoyl group,
Z is an atomic group that forms an aromatic ring,
X is a divalent linkage group, and
A is a copolymerized monomer unit derived from a vinyl monomer.

2. The organic light-emitting element material as claimed in claim 1, wherein X in the formula (1a) is selected from an alkylene group, an arylene group and a divalent aromatic heterocyclic group.

3. The organic light-emitting element material as claimed in claim 1 or 2, wherein the aromatic ring formed from Z in the formula (1a) is a benzene ring.

4. The organic light-emitting element material as claimed in claim 3, which is a high-molecular compound comprising k% by mol (0<k≤100) of a constitutional unit represented by the following formula (2a) and n% by mol (0≤n<100 and k+n=100) of a constitutional unit represented by the following formula (2b): 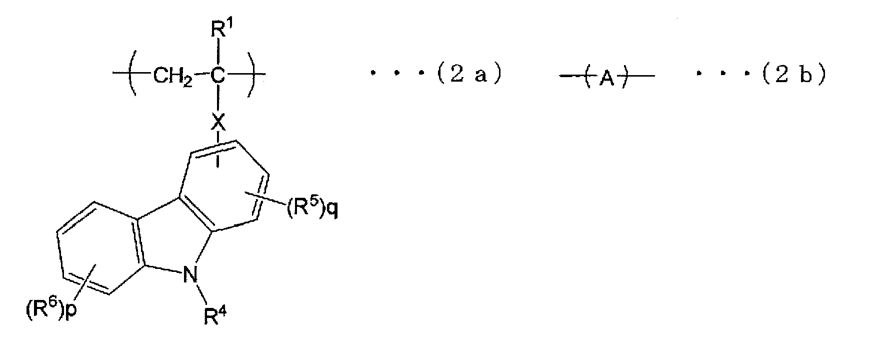 wherein R¹ is a hydrogen atom or a methyl group,
R⁴ is a hydrogen atom, or a substituted or unsubstituted alkyl group, alkenyl group, alkynyl group, aryl group, heterocyclic group, alkylcarbonyl group, arylcarbonyl group, alkylsulfonyl group, arylsulfonyl group, alkoxycarbonyl group, aryloxycarbonyl group, carbamoyl group or sulfamoyl group,
R⁵ and R⁶ are each independently a substituent group,
p is an integer of 0 to 4,
q is an integer of 0 to 3,
X is a divalent linkage group, and
A is a copolymerized monomer unit derived from a vinyl monomer.

5. An organic light-emitting element which is an organic light-emitting element having an organic layer(s) between a pair of electrodes, wherein at least one of the organic layers contains the organic light-emitting element material as claimed in any one of claims 1 to 4.

6. The organic light-emitting element as claimed in claim 5, wherein at least one of the organic layer (s) comprises a luminescent material capable of light emission from a triplet exciton.

7. An organic light-emitting element having a hole injection electrode layer, an electron injection electrode layer and a dielectric layer interposed between the hole injection electrode layer and the electron injection electrode layer,
having a cavity which extends through the dielectric layer and at least one of these electrode layers and has an internal cavity surface provided with a hole injection electrode region, an electron injection electrode region and a dielectric region, and
having an organic layer which comprises the organic light-emitting element material as claimed in any one of claims 1 to 4 and is in electrical contact with the hole injection electrode region and the electron injection electrode region on the internal cavity surface.

8. The organic light-emitting element as claimed in claim 7, wherein the organic layer contains a luminescent material capable of light emission from a triplet exciton.

9. A process for producing an organic light-emitting element, which is a process for producing an organic light-emitting element having an organic layer between a pair of electrodes, the said process comprising a step of forming the organic layer comprising the organic light-emitting element material as claimed in any one of claims 1 to 4 on one of the electrodes and a step of forming the other of the electrodes on the organic layer.

10. The process for producing an organic light-emitting element as claimed in claim 9, wherein the step of forming the organic layer comprises applying a liquid comprising at least the organic light-emitting element material as claimed in any one of claims 1 to 4 onto one of the electrodes to form the organic layer.

11. A process for producing an organic light-emitting element comprising:
a step of forming a laminated structure having a hole injection electrode layer, an electron injection electrode layer and a dielectric layer interposed between the hole injection electrode layer and the electron injection electrode layer and having a cavity which extends through the dielectric layer and at least one of these electrode layers and has an internal cavity surface provided with a hole injection electrode region, an electron injection electrode region and a dielectric region, and
a step of forming an organic layer comprising the organic light-emitting element material as claimed in any one of claims 1 to 4 on the internal cavity surface in such a manner that the organic layer comes into electrical contact with the hole injection electrode region and the electron injection electrode region on the internal cavity surface.

12. The process for producing an organic light-emitting element as claimed in claim 11, wherein the organic layer further contains a luminescent material capable of light emission from a triplet exciton.
